# EUROPÄISCHE PATENTSCHRIFT

(11) **EP 0 740 795 B1**
(45) Veröffentlichungstag und Bekanntmachung des Hinweises auf die Patenterteilung: **25.03.1998**
(21) Anmeldenummer: 95905040.2
(22) Anmeldetag: 09.01.1995
(51) Int. Cl.: G01R 1/067

(54) **VORRICHTUNG FÜR REVERSIBLE CHIPKONTAKTIERUNG**
REVERSIBLE CHIP CONTACTING DEVICE
DISPOSITIF DE MISE EN CONTACT REVERSIBLE DE PLAQUETTES DE CIRCUITS IMPRIMES

(30) Priorität: 11.01.1994 DE 4400551
(43) Veröffentlichungstag der Anmeldung: 06.11.1996
(73) Patentinhaber: SIEMENS AKTIENGESELLSCHAFT, 80333 München (DE)
(72) Erfinder: HÜBNER, Holger, D-85598 Baldham (DE); WEBER, Werner, D-80637 München (DE); KÖPPE, Siegmar, D-30880 Laatzen (DE); KLOSE, Helmut, D-81929 München (DE)
(86) Internationale Anmeldenummer: DE9500013
(87) Internationale Veröffentlichungsnummer: WO9518975

(56) Entgegenhaltungen:
- DE-B- 2 440 305
- US-A- 4 409 546

## Beschreibung

Die vorliegende Erfindung betrifft eine Vorrichtung für reversible Kontaktierungen einer Halbleiterschaltungsebene für den Funktionstest und ein Verfahren zum Testen von Halbleiterschaltungsebenen unter Verwendung einer solchen Vorrichtung.

Halbleiterschaltungen werden heute in Planartechnik hergestellt. Die erreichbare Komplexität auf einem Chip ist begrenzt durch dessen Große und die erreichbare Strukturfeinheit. Die Leistungsfähigkeit eines Systems bestehend aus mehreren miteinander verbundenen Halbleiterchips ist bei konventioneller Technik wesentlich begrenzt durch die begrenzte Zahl der möglichen Verbindungen zwischen einzelnen Chips über Anschlußkontakte (Pads), die geringe Geschwindigkeit der Signalübermittlung über solche Verbindungen zwischen verschiedenen Chips (Interface-Schaltung Pad/Leiterplatte), die bei komplexen Chips begrenzte Geschwindigkeit durch weit verzweigte Leiterbahnen und den hohen Leistungsverbrauch der Interface-Schaltungen.

Diese aufgezeigten Beschränkungen bei der Verwendung der Planartechnik lassen sich mit dreidimensionalen Techniken der Verschaltung überwinden. Die Anordnung der Funktionsebenen übereinander erlaubt eine parallele Kommunikation dieser Komponenten mit geringem Aufwand elektrisch leitender Verbindungen in einer Ebene, und außerdem werden geschwindigkeitsbegrenzende Interchip-Verbindungen vermieden. Außerdem kann ein solcher kubisch integrierter Halbleiterchip trotz gesteigerter Funktionalität in demselben Gehäuse untergebracht werden.

Um keinen unnötigen Verlust bei der Ausbeute funktionsfähiger Chips zu erleiden, ist es erforderlich, daß nur getestete und als voll funktionstüchtig befundene Schaltungsebenen übereinandergesetzt und kontaktiert werden. Das ist solange unproblematisch , wie es sich bei den Schaltungsebenen um autarke, d. h. selbständig funktionierende Schaltungen handelt. Bei solchen Schaltungen ist es möglich, sie schon auf dem Wafer, auf dem sie hergestellt werden, zu testen, bevor man sie passiviert, vereinzelt und in Gehäusen montiert. Wenn die Schaltungsebene allerdings erst im Zusammenspiel mit ihren vertikal benachbarten Schaltungsebenen funktioniert, dann ist das Testen dieser Schaltungsebene ohne weitere Maßnahmen erst nach dem irreversiblen Zusammenbau der verschiedenen schaltungsebenen möglich, was aber vermieden werden soll, weil ein solches Vorgehen die erreichbare Ausbeute drastisch verringert.

Üblicherweise werden die Schaltungen zum Testen durch Aufsetzen feiner Prüfspitzen auf die Bondpads kontaktiert. Die Pads haben aber wesentlich größere Abmessungen als die Verbindungskontakte der Schaltungsebenen, die für die kubische Integration vorgesehen sind. Dabei ist außerdem die Zahl der Kontakte wesentlich größer (etwa 10.000 bis 100.000). Die feinen Abmessungen und die hohe Anzahl der Kontaktstellen schließen die Verwendung der üblichen Testspitzen aus. Ein anderes Testverfahren verwendet elektronenoptische Methoden. Dies erfordert aber autarke Schaltungsebenen, eine Voraussetzung, die wie erwähnt bei kubischer Integration nicht erfüllt ist. Insbesondere ist bei isolierten Schaltungsebenen die Spannungsversorgung noch nicht gewährleistet. Diese Testverfahren sind daher zum Testen einzelner Halbleiterschaltungsebenen, die für kubische Integration vorgesehen sind, nicht anwendbar.

In der US 4,409,546 ist eine Vorrichtung beschrieben mit der elektrische Anschlüsse auf einer Halbleiterscheibe provisorisch kontaktiert werden können. Diese Testvorrichtung besteht im wesentlichen aus einer Platte an deren Unterseite Kapillaren, die mit einem Quecksilberreservoir verbunden sind, münden. An den Kapillaren sind elektrisch leitende Verbindungen zu Testschaltungen angebracht. Um Segmente des in den Kapillaren geführten Quecksilbers zwischen den Öffnungen und diesen elektrischen Verbindungen von dem restlichen Quecksilber trennen zu können, sind an den Kapillaren Anschlüsse für die Zufuhr von Luft vorgesehen. In der DE AS 24 40 305 ist eine Meßelektrode mit flüssigem Metall beschrieben, bei der sich in einem Hohlraum Gallium oder eine flüssige Galliumlegierung befindet.

Äufgabe der vorliegenden Erfindung ist es, eine Möglichkeit anzugeben, wie Halbleiterschaltungsebenen, insbesondere solche mit nicht autarken Schaltungen, vor der kubischen Integration einem Funktionstest unterzogen werden können.

Diese Aufgabe wird mit der Vorrichtung mit den Merkmalen des Anspruches 1 bzw. mit dem Verfahren mit den Merkmalen des Anspruches 10 gelöst. Weitere Ausgestaltungen ergeben sich aus den abhängigen Ansprüchen.

Bei der erfindungsgemäßen Vorrichtung wird die reversible Kontaktierung einer Halbleiterschaltungsebene in der Weise realisiert, daß flüssige Kontakte an den für die Kontaktierung vorgesehenen Stellen in einem Testkopf installiert werden. Es kann dann die Halbleiterschaltungsebene, die getestet werden soll, mit diesem Testkopf in Verbindung gebracht werden und über die Flüssigkontakte des Testkopfs mit angeschlossenen leitenden Verbindungen der elektrische Anschluß für den Funktionstest erfolgen. Derartige Kontakte lassen sich leicht in großer Stückzahl auf kleinstem Raum und bei kleinsten individuellen Abmessungen herstellen. Der Testkopf kann dann ggf. Kontakte für verschiedene Schaltungsebenen besitzen, so daß derselbe Testkopf für die Tests verschiedener für die kubische Integration vorgesehener Schaltungsebenen verwendet werden kann. Die einzelne Schaltungsebene ist nur reversibel mit dem Testkopf verbunden und kann ohne Beschädigung von diesem getrennt werden. Der Testkopf kann eine integrierte Schaltung mit der zum Betrieb und Testen der betreffenden Schaltungsebene erforderlichen Logik enthalten.

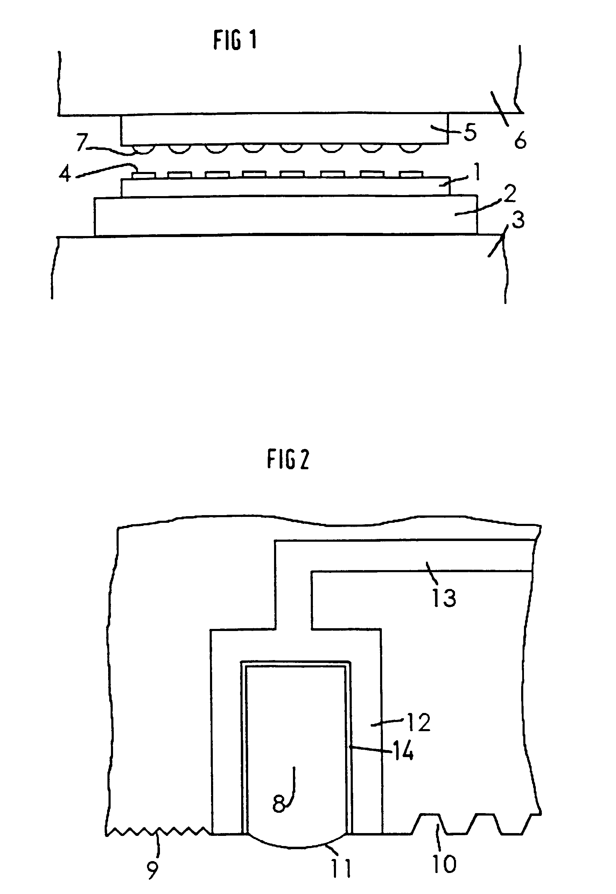

Der prinzipielle Aufbau der erfindungsgemäßen Vorrichtungen und deren Anwendungen lassen sich am einfachsten anhand der Figuren 1 und 2 beschreiben.
- Fig. 1: zeigt die Anwendung des Testkopfes auf eine Schaltungsebene.
- Fig. 2: zeigt die Ausgestaltung eines Kontaktes des Testkopfes im Querschnitt.

Bei dem Funktionstest entsprechend der Anordnung von Fig. 1 ist die zu testende Schaltungsebene 1 auf der Unterseite fest mit einer Trägerplatte 2 verbunden, die einerseits der mechanischen Stabilisierung der dünnen Schaltungsebene 1 dient und andererseits dem Abführen der Wärme in eine damit verbundene Wärmesenke 3. In Fig. 1 sind im Schema die für eine vertikale Kontaktierung mit einer darüber zu montierenden weiteren Schaltungsebene vorgesehenen Kontaktflächen 4 auf der Oberseite dieser zu testenden Schaltungsebene 1 eingezeichnet. Der Testkopf 5 der erfindungsgemäßen Vorrichtung ist vorteilhaft z. B. ebenfalls an eine Wärmesenke 6 gekoppelt und wird mit den Testkontakten 7 zur zu testenden Schaltungsebene 1 hin ausgerichtet. Bei dem Testkopf 5 sind diese Testkontakte 7 den elektrisch anzuschließenden Kontaktflächen 4 der Schaltungsebene 1 gegenüberliegend angeordnet. Wie erwähnt kann der Testkopf 5 zusätzliche Testkontakte 7 enthalten, die z. B. zum Testen weiterer Schaltungsebenen dienen. Die Testkontakte 7 können mit dünnflüssigem, viskosem oder elastischem Material gebildet sein. Diese Materialien werden im folgenden und in den Ansprüchen einheitlich als Flüssigkontakte bezeichnet. Wie mit derartigen Flüssigkontakten die Testkontakte 7 aufgebaut sein können, läßt sich aus der Fig. 2 ersehen.

Die Fig. 2 zeigt einen Ausschnitt aus der für die Verbindung mit einer Schaltungsebene vorgesehenen Oberseite des Testkopfes 5 im Querschnitt. Dieser Ausschnitt zeigt einen einzelnen Testkontakt. Dieser Testkontakt ist in einer in diesem Beispiel zylindrischen Aussparung in der Oberseite des Testkopfes hergestellt. Die Wände dieser zylindrischen Aussparung sind mit einer Metallisierung 12 bedeckt. An diese Metallisierung 12 ist eine elektrisch leitende Verbindungsleitung 13 für den elektrischen Anschluß des betreffenden Testkontaktes geführt. Im Innern der Aussparung befindet sich der Flüssigkontakt 8, dessen Oberfläche einen sich nach außen vorwölbenden Meniskus 11 bildet. Diese Flüssigkontakte 8 und die Metallisierung 12 müssen respektive aus Materialien hergestellt sein, die so beschaffen sind, daß die Metallisierung der Wände sich nicht in dem Material des Flüssigkontaktes 8 lösen kann oder durch chemische Reaktionen damit Schaden nimmt. Andererseits muß die Flüssigkeit die Metallisierung benetzen, um guten elektrischen Kontakt zu gewährleisten. Diese Voraussetzungen sind z. B. erfüllt, wenn für die Flüssigkontakte 8 ein Metall mit niedrigem Schmelzpunkt wie z. B. Ga und für die Metallisierung 12 ein in der Mikroelektronik übliches Metall wie z. B. Al oder W verwendet wird und zwischen beiden Metallen eine geeignete, elektrisch leitfähige Diffusionsbarriere 14 wie z. B. TiN aufgebracht wird. Grundsätzlich ist aber für die Flüssigkontakte 8 eine beliebige elektrisch leitfähige Flüssigkeit (z. B. Elektrolyt, Ferrofluid oder dgl.) verwendbar. Vorzugsweise wird dafür ein flüssiges Metall (wie das genannte Gallium) verwendet. In einer speziellen Ausgestaltung kann der Testkopf mit magnetischen Metallisierungen 12 versehen sein. Wenn als Flüssigkontakte 8 ein elektrisch leitfähiges Ferrofluid (z. B. ein Elektrolyt mit suspendierten magnetischen Teilchen) verwendet wird, dann konzentrieren die Magnetkräfte den Flüssigkeitstropfen auf den Bereich der Kontaktfläche 4. Statt einer Flüssigkeit kann für die Flüssigkontakte 8 ein hochelastischer, elektrisch leitfähiger Kunststoff verwendet werden. Derartige Testkontakte 7 mit über die Oberfläche ragendem Kunststoff geben einerseits federnd nach und können damit mechanische Toleranzen der Oberfläche der Schaltungsebene ausgleichen und lassen sich andererseits im Anschluß an den Test rückstandsfrei abnehmen. Das Testverfahren ist damit vereinfacht, weil eine anschließende Reinigung der Schaltungsebene erspart ist und auch ein Kontaminationsproblem nicht auftritt. Die Diffusionsbarriere 14 kann bei Verwendung von Kunststoff für die Flüssigkontakte 8 weggelassen sein. Die Metallisierung 12 ist vorteilhaft, kann aber auch weggelassen sein, wenn der elektrisch leitende Kunststoff z. B. in eine Aussparung in einem ausreichend hoch dotierten, diese Aussparung umgebenden Bereich des Halbleitermateriales eingesetzt ist. Diese Ausführungsform entspräche dann der in Fig. 2 gezeichneten ohne die Schichten 12 und 14.

Allgemein läßt sich sagen, daß die Oberseite des erfindungsgemäßen Testkopfes 5 sich mit der Oberseite der zu testenden Schaltungsebene nicht zu fest verbinden darf, damit die Schaltungsebene beim Losen der Verbindung mit dem Testkopf nach dem Test nicht zerbricht. Daher muß vermieden werden, daß die beiden zeitweise verbundenen Oberflächen zu starke Adhäsionskräfte aufeinander ausüben. Das kann durch eine entsprechende Präparation der mit der Schaltungsebene zu verbindenden Oberseite des Testkopfes erfolgen. Eine Möglichkeit ist z. B., die Oberseite durch eine Aufrauhung 9 (s. Fig. 2) oder durch eingeätzte Gräben 10 so uneben zu machen, daß der Kontakt zwischen dem Testkopf 5 und der Schaltungsebene 1 nur noch punktuell erfolgt. Eine Verminderung der Adhäsionskräfte kann auch mit einer Beschichtung der Oberseite des Testkopfes zwischen den Testkontakten 7 mit einer geeigneten Antiadhäsionsschicht erreicht werden.

Die mit den Testkontakten 7 versehene Oberseite des Testkopfes darf beim Kontaktieren einer Schaltungsebene von der elektrisch leitenden Flüssigkeit der Flüssigkontakte 8 nicht benetzt werden, weil anderenfalls Kurzschlüsse zwischen den Kontakten auftreten könnten. Das Einbringen der Flüssigkeit in die Aussparungen des Testkopfes geschieht z. B. durch Aufgießen und anschließendes Abschleudern der auf der Oberfläche stehenden überschüssigen Flüssigkeit. Dabei bilden sich die in Fig. 2 dargestellten Menisken 11, die die in Fig. 1 dargestellten, über die Oberseite des Testkopfes 5 hinausragenden Anteile der Testkontakte 7 bilden, aus. Beim Umdrehen des Testkopfs in die in Fig. 1 gezeigte Lage hängen diese Flüssigkontakte 8 nach unten und werden durch die Kohäsionskräfte daran gehindert herauszulaufen. Der elektrische Kontakt entsteht bei Annäherung des Testkopfs an die zu testende Schaltungsebene, indem die Flüssigkeit die Kontaktflächen 4 benetzt. Da die Flüssigkontakte 8 über die Oberseite des Testkopfes 5 hinausragen, wird beim Kontaktieren ein Ausgleich von Unebenheiten der Oberfläche der zu testenden Schaltungsebene erreicht, wie man es etwa bei mechanischen Kontakten durch federnde Lagerung der Testspitzen erreichen würde.

## Patentansprüche

1. Vorrichtung zur reversiblen Kontaktierung einer Halbleiterschaltungsebene,
bei der in einem Testkopf (5) mit im wesentlichen ebener Oberseite Testkontakte (7) an für eine Kontaktierung mit der Halbleiterschaltungsebene vorgesehenen Stellen angeordnet sind,
bei der diese Testkontakte (7) durch Flüssigkontakte (8) gebildet sind, die sich jeweils in einer Aussparung an der Oberseite des Testkopfes (5) befinden,
bei der diese Aussparung von elektrisch leitendem Material umgeben ist und der Flüssigkontakt (8) mit diesem Material in elektrisch leitender Verbindung steht, und
bei der eine freie Oberfläche dieser Flüssigkontakte (8) jeweils über diese Oberseite hinausragt.

2. Vorrichtung nach Anspruch 1,
bei der die Wände der Aussparung mit einer Metallisierung (12) versehen sind und
bei der diese Metallisierung (12) mit einer elektrisch leitenden Verbindungsleitung (13) für elektrischen Anschluß verbunden ist.

3. Vorrichtung nach Anspruch 1 oder 2,
bei der die Flüssigkontakte (8) ein flüssiges Metall sind.

4. Vorrichtung nach Anspruch 3,
bei der die Flüssigkontakte (8) Gallium sind.

5. Vorrichtung nach Anspruch 2,
bei der die Flüssigkontakte (8) ein elektrisch leitfähiges Ferrofluid sind und
bei der die Metallisierungen (12) magnetisch sind.

6. Vorrichtung nach Anspruch 1 oder 2,
bei der die Flüssigkontakte (8) hochelastischer, elektrisch leitfähiger Kunststoff sind.

7. Vorrichtung nach einem der Ansprüche 1 bis 6,
bei der die Oberseite des Testkopfes (5) eine Aufrauhung (9) zwischen den Testkontakten (7) aufweist.

8. Vorrichtung nach einem der Ansprüche 1 bis 6,
bei der die Oberseite des Testkopfes (5) Gräben (10) in den nicht von den Testkontakten (7) eingenommenen Bereichen aufweist.

9. Vorrichtung nach einem der Ansprüche 1 bis 6,
bei der die Oberseite des Testkopfes (5) zwischen den Testkontakten (7) mit einer Antiadhäsionsschicht bedeckt ist.

10. Verfahren zur Durchführung von Funktionstests an einer Halbleiterschaltungsebene,
bei dem die zu testende Halbleiterschaltungsebene mit einer Vorrichtung nach einem der Ansprüche 1 bis 9 in Kontakt gebracht wird und ein elektrischer Anschluß über die Verbindungsleitungen (13) dieser Vorrichtung vorgenommen wird und im Anschluß an die Funktionstests diese Vorrichtung entfernt wird.

## Claims

1. Device for reversibly making contact with a semiconductor circuit plane,
in which device testing contacts (7) are arranged in a testing head (5) having an essentially planar upper side, at points envisaged for making contact with the semiconductor circuit plane,
in which device these testing contacts (7) are formed by liquid contacts (8) which are respectively located in a recess on the upper side of the testing head (5),
in which device this recess is surrounded by electrically conductive material and the liquid contact (8) is electrically conductively connected to this material, and
in which device a free surface of these liquid contacts (8) in each case projects beyond this upper side.

2. Device according to Claim 1,
in which the walls of the recess are provided with metallizing (12) and
in which this metallizing (12) is connected to an electrically conductive connecting line (13) for electrical connection.

3. Device according to Claim 1 or 2, in which the liquid contacts (8) are a liquid metal.

4. Device according to Claim 3, in which the liquid contacts (8) are gallium.

5. Device according to Claim 2,
in which the liquid contacts (8) are an electrically conductive ferrofluid, and
in which the metallization (12) is magnetic.

6. Device according to Claim 1 or 2, in which the liquid contacts (8) are highly elastic, electrically conductive plastic.

7. Device according to one of Claims 1 to 6, in which the upper side of the testing head (5) has a roughening (9) between the testing contacts (7).

8. Device according to one of Claims 1 to 6, in which the upper side of the testing head (5) has trenches (10) in the regions not occupied by the testing contacts (7).

9. Device according to one of Claims 1 to 6, in which the upper side of the testing head (5) is covered with an anti-adhesion layer between the testing contacts (7).

10. Method of carrying out functional tests on a semiconductor circuit plane,
in which method the semiconductor circuit plane to be tested is brought into contact with a device according to one of Claims 1 to 9 and an electrical connection is made via the connecting lines (13) of this device, and this device is removed after the functional tests.

## Revendications

1. Dispositif de mise en contact réversible d'un plan de circuit semi-conducteur,
dans lequel sont disposés dans une tête de test (5) avec une surface essentiellement plane des contacts de test (7) aux endroits prévus pour la mise en contact avec le plan de circuit semi-conducteur,
dans lequel ces contacts de test (7) sont formés par des contacts liquides (8), qui se trouvent respectivement dans un évidement à la face supérieure de la tête de test (5),
dans lequel cet évidement est entouré de matériau électro-conducteur et le contact liquide (8) est en contact électro-conducteur avec ce matériau, et
dans lequel une surface libre de ces contacts liquides (8) dépasse à chaque fois cette face supérieure.

2. Dispositif selon la revendication 1,
dans lequel les parois de l'évidement sont munies d'une métallisation (12) et
dans lequel cette métallisation (12) est reliée à une conduite de connexion (13) électro-conductrice pour le raccord électrique.

3. Dispositif selon la revendication 1 ou 2,
dans lequel les contacts liquides (8) sont un métal liquide.

4. Dispositif selon la revendication 3,
dans lequel les contacts liquides (8) sont du gallium.

5. Dispositif selon la revendication 2,
dans lequel les contacts liquides (8) sont un ferrofluide électro-conducteur et
dans lequel les métallisations (12) sont magnétiques.

6. Dispositif selon la revendication 1 ou 2,
dans lequel les contacts liquides (8) sont une matière synthétique électro-conductrice très élastique.

7. Dispositif selon l'une des revendications 1 à 6,
dans lequel la face supérieure de la tête de test (5) présente des rugosités (9) entre les contacts de test (7).

8. Dispositif selon l'une des revendications 1 à 6,
dans lequel la face supérieure de la tête de test (5) présente des rainures (10) dans les régions non occupées par les contacts de test (7).

9. Dispositif selon l'une des revendications 1 à 6,
dans lequel la face supérieure de la tête de test (5) est recouverte d'une couche anti-adhésive entre les contacts de test (7).

10. Procédé pour la réalisation de tests de fonctionnement sur un plan de circuit semi-conducteur,
dans lequel le plan de circuit semi-conducteur à tester est mis en contact avec un dispositif selon l'une des revendications 1 à 9 et dans lequel un raccord électrique est effectué par les conduites de connexion (13) de ce dispositif et
dans lequel ce dispositif est enlevé après les tests de fonctionnement.
